# EUROPÄISCHE PATENTSCHRIFT

(11) **EP 2 630 709 B1**
(45) Veröffentlichungstag und Bekanntmachung des Hinweises auf die Patenterteilung: **02.03.2016**
(21) Anmeldenummer: 11796667.1
(22) Anmeldetag: 08.12.2011
(51) Int. Cl.: H02G 3/16

(54) **VERFAHREN ZUM ANSCHLIESSEN ZUMINDEST ZWEIER ELEKTRISCHER KABEL SOWIE ANSCHLUSSVORRICHTUNG, BAUSATZ, ELEKTRISCHE MASCHINE UND FAHRZEUG HIERFÜR**
METHOD FOR CONNECTING AT LEAST TWO ELECTRIC CABLES AND CONNECTION DEVICE, KIT, ELECTRIC MACHINE AND ASSOCIATED VEHICLE
PROCÉDÉ POUR RACCORDER AU MOINS DEUX CÂBLES ÉLECTRIQUES ET DISPOSITIF DE RACCORDEMENT, ENSEMBLE PRÊT-À-MONTER, MOTEUR ÉLECTRIQUE ET VÉHICULE CORRESPONDANTS

(30) Priorität: 21.12.2010 DE 102010063776
(43) Veröffentlichungstag der Anmeldung: 28.08.2013
(73) Patentinhaber: Siemens Aktiengesellschaft, 80333 München (DE)
(72) Erfinder: LANGE, Thomas, 90763 Fürth (DE); PITTIUS, Ekkehard, 91154 Roth (DE); SCHMIDT, Valerias, 90471 Nürnberg (DE)
(86) Internationale Anmeldenummer: PCT/EP2011/072219
(87) Internationale Veröffentlichungsnummer: WO 2012/084534

(56) Entgegenhaltungen:
- EP-A1- 0 961 376
- DE-U- 1 912 962
- FR-A1- 2 628 577
- GB-A- 145 356
- US-B1- 7 342 173

## Beschreibung

Die Erfindung betrifft eine Anschlussvorrichtung zum Anschluss zumindest zweier elektrischer Kabel an eine elektrische Maschine eines Fahrzeugs, mit einem Gehäuse und zumindest zwei Kontaktelementen, wobei in einer Gehäusewand zumindest zwei erste Öffnungen zur Durchführung jeweils eines der Kabel so angeordnet sind, dass alle in einer ersten Richtung durch die ersten Öffnungen in das Gehäuse geführten und in der ersten Richtung geradlinig innerhalb des Gehäuses weiterverlaufenden Kabel jeweils auf genau eines der Kontaktelemente treffen. Die Erfindung betrifft auch einen Bausatz mit einer solchen Anschlussvorrichtung, einer elektrischen Maschine mit einer solchen Anschlussvorrichtung, ein Fahrzeug mit einer solchen elektrischen Maschine sowie ein Verfahren zum Anschließen zumindest zweier elektrischer Kabel.

Für Starkstromgeräte sind in der Regel in speziell hierfür ausgebildeten Klemmkästen Leistungsanschlüsse vorgesehen. Die Form und Ausgestaltung des Klemmkastens muss hierbei häufig auf beengte Platzverhältnisse Rücksicht nehmen. Beengte Platzverhältnisse herrschen insbesondere bei Fahrmotoren im Drehgestellbereich von Schienenfahrzeugen sowie in der Radnabe von Muldenkippern. Es ist üblich, in diesem Fall stets individuelle Kundenlösungen zu konstruieren, die den Kabelaustritt aus einem geschweißten oder gegossenen Klemmkasten immer nur in eine Richtung ermöglichen. Ähnliche Anwendungen erlauben zwar meist den Einsatz identischer Motoren, jedoch werden die zu den Motoren gehörigen Klemmkästen entsprechend der Anschlusswünsche des Kunden geeignet modifiziert. Auch eine Ausgestaltung mit Zusatzklemmkästen ist möglich. Die De 1912962 U offenbart eine Anschlussvorrichtung mit Kabelöffrungen in jeden Gehäusewand und kreuzförming diagonal angeorduchen Kontakt elementen.

Es ist Aufgabe der Erfindung, eine Anschlussmöglichkeit für Kabel bereitzustellen, bei der verschiedene Kabelführungen ermöglicht werden, ohne dass für den Anschluss baulich umfangreiche Variationen erforderlich wären. Auch beengten Platzverhältnissen soll besser Rechnung getragen werden.

Diese Aufgabe wird durch eine Anschlussvorrichtung, welche die Merkmale des Patentanspruchs 1 aufweist, einen Bausatz, welcher die Merkmale des Patentanspruchs 8 aufweist, einen Elektromotor mit den Merkmalen des Patentanspruchs 10, ein Fahrzeug mit den Merkmalen des Patentanspruchs 11 sowie ein Verfahren, welches die Merkmale des Patentanspruchs 12 aufweist, gelöst.

Die erfindungsgemäße Anschlussvorrichtung dient zum Anschluss zumindest zweier elektrischer Kabel an eine elektrische Maschine eines Fahrzeugs. Sie umfasst ein Gehäuse und zumindest zwei Kontaktelemente, wobei in einer Gehäusewand des Gehäuses zumindest zwei erste Öffnungen zur Durchführung jeweils eines der Kabel so angeordnet sind, dass alle in einer ersten Richtung durch die ersten Öffnungen in das Gehäuse geführten und in der ersten Richtung geradlinig innerhalb des Gehäuses weiterverlaufenden Kabel jeweils auf genau eines der Kontaktelemente treffen. Das Gehäuse kann insbesondere mehrere Gehäusewände umfassen, die gemeinsam einen Gehäuseinnenraum umschließen. Die Gehäusewände können insbesondere im Wesentlichen senkrecht aufeinander stehen. Es sind jedoch auch Abweichungen von einer kubischen Gehäuseform denkbar, so dass die Gehäusewände in Form eines Trapezes zueinander angeordnet sind. Die Wände können hierbei auch gegeneinander verkippt angeordnet sein. Das Gehäuse kann insbesondere auch mehrstückig ausgebildet sein. Die Kabel können insbesondere senkrecht zu einer Gehäusewand durch die jeweiligen Öffnungen in dieser Gehäusewand in das Gehäuse geführt werden. Innerhalb des Gehäuses verlaufen die Kabel insbesondere vollständig geradlinig, das heißt, dass keines der Kabel gebogen oder abgewinkelt geführt wird, um auf sein zugehöriges Kontaktelement zu treffen. Alternativ können die Kabel innerhalb des Gehäuses zwar im Wesentlichen geradlinig weiterverlaufen, dabei jedoch geringfügige Biegungen und Abwinklungen aufweisen, die jedoch auf die prinzipielle Tendenz der Verlaufsrichtung keinen Einfluss haben. Insbesondere kann der Kabelverlauf im Rahmen der üblichen Toleranzen von einer perfekten Geraden abweichen.

Erfindungsgemäß sind in der Gehäusewand zumindest zwei zweite Öffnungen zur Durchführung jeweils eines der Kabel so angeordnet, dass unter den in einer zweiten Richtung durch die zweiten Öffnungen in das Gehäuse geführten und in der zweiten Richtung geradlinig innerhalb des Gehäuses weiterverlaufenden Kabel ausschließlich eines direkt auf genau eines der Kontaktelemente trifft. Dieses Kabel ist dann mit dem zugehörigen Kontaktelement elektrisch verbindbar. Alle übrigen Kabel sind mit jeweils einem der übrigen Kontaktelemente mittels jeweils einer Leiterschiene elektrisch verbindbar. Insbesondere treffen die übrigen Kontaktelemente nicht direkt auf das ihnen zugehörige Kontaktelement. Die zweite Richtung verläuft im Wesentlichen senkrecht zur ersten Richtung. Dann können insbesondere die ersten und zweiten Öffnungen jeweils in zueinander senkrechten Ebenen liegen.

Auf diese Art können in ein und dieselbe Anschlussvorrichtung Kabel in zwei verschiedenen, zueinander im Wesentlichen senkrecht stehenden Richtungen geführt werden. Ein elektrischer Anschluss aller Kabel ist für beide Führungsvarianten problemlos möglich. Es ist damit eine sehr variable Anschlussmöglichkeit für die Kabel bereitgestellt. Möchte man statt einer ersten Anschlussoption mit einer ersten Kabelführungsrichtung eine zweite Anschlussoption mit einer hierzu im Wesentlichen senkrechten Kabelführungsrichtung realisieren, muss keine neue Anschlussvorrichtung bereitgestellt werden, sondern es kann die erfindungsgemäße Anschlussvorrichtung verwendet werden. Auf diese Weise ist eine standardisierte und universell einsetzbare Anschlussvorrichtung geschaffen und eine kostengünstig zu realisierende Kundenlösung bereitgestellt. Die Kabelführung ist berechenbar und transparent, sodass Anschlussfehler vermieden werden und ein hohes Maß an Installationssicherheit gewährleistet ist. Die Anschlussvorrichtung ist zudem äußerst platzsparend.

Vorzugsweise umfasst die Anschlussvorrichtung ein Aufnahmeelement, welches einem der Kontaktelemente zugeordnet ist. Das Aufnahmeelement gibt eine räumliche Anordnung für ein Unterstützungselement vor, welches für die Abstützung einer der Leiterschienen ausgebildet ist. Das Unterstützungselement ist an dem Aufnahmeelement befestigbar. Die Anschlussvorrichtung ist damit für die zumindest zwei Anschlussoptionen optimal vorbereitet. Um die Kontaktelemente über die Leiterschienen mit den in der zweiten Richtung geführten Kabeln zu verbinden, müssen lediglich geeignete Unterstützungselemente in die hierfür vorgesehenen Aufnahmeelemente eingebracht und dort befestigt werden, um eine sehr gute Abstützung für die jeweilige Leiterschiene zu gewährleisten. Insbesondere kann auch die Leiterschiene an dem Unterstützungselement befestigbar sein. Das Aufnahmeelement kann insbesondere eine vorgehaltene Aussparung für das Unterstützungselement sein. Die Aufnahmeelemente geben intuitiv erfassbare Soll-Positionen für die Unterstützungselemente vor, sodass ein fehlerhafter Anschluss der Kabel an die Kontaktelemente zuverlässig verhindert wird.

Vorzugsweise sind zumindest zwei Kontaktelemente entlang einer Geraden angeordnet, welche in der zweiten Richtung verläuft. Es ergibt sich eine einfache und leicht nachvollziehbare im Wesentlichen rechtwinklige geometrische Anordnung, die den Anschluss der Kabel erleichtert und zur Standardisierung der Anschlussvorrichtung beiträgt.

Vorzugsweise sind die zumindest zwei Kontaktelemente in einem Sockelelement eingebettet. Sie sind dann ausschließlich von einer Seite des Kontaktelements elektrisch kontaktierbar, welche in der von der ersten und zweiten Richtung aufgespannten Ebene liegt. Insbesondere können die Kontaktelemente so in das Sockelelement eingebettet sein, dass sie von keiner der Seiten, die im Wesentlichen senkrecht zur ersten und/oder zweiten Richtung stehen, elektrisch kontaktierbar sind. Die einzige elektrisch kontaktierbare Seite jedes Kontaktelements hat damit eine Normale, welche senkrecht auf den zur ersten und zweiten Richtung gehörenden Richtungsvektoren steht. Diese Anschlussart ist sicher und zweckmäßig. Unerwünschte Kurzschlüsse können zuverlässig vermieden werden. Die Kabel lassen sich sicher und einfach an den Kontaktelementen befestigen.

Vorzugsweise ist an dem Sockelelement zumindest ein Isoliersteg ausgebildet, welcher zwischen zwei benachbarten unter den zumindest zwei Kontaktelementen so verläuft, dass eine gleichzeitige elektrische Kontaktierung der zwei benachbarten Kontaktelemente durch ein geradlinig entlang der zweiten Richtung verlaufendes Kabel verhindert ist. Auf diese Weise wird ein unerwünschter Kurzschluss zwischen zwei benachbarten Kontaktelementen sicher vermieden. Fehlanschlüsse der in der zweiten Richtung verlaufenden Kabel werden verhindert. Auch die Wahrscheinlichkeit von Kurzschlüssen durch Metallspäne, Feuchtigkeit, Schmutz etc. ist verringert.

Vorzugsweise sind in der Gehäusewand zumindest zwei dritte Öffnungen zur Durchführung jeweils eines der Kabel so angeordnet, dass unter den in einer dritten Richtung durch die dritten Öffnungen in das Gehäuse geführten und in der dritten Richtung geradlinig innerhalb des Gehäuses weiterverlaufenden Kabel ausschließlich eines direkt auf genau eines der Kontaktelemente trifft und mit diesem elektrisch verbindbar ist und alle übrigen mit jeweils einem der übrigen Kontaktelemente mittels jeweils einer Leiterschiene elektrisch verbindbar sind, wobei die dritte Richtung im Wesentlichen antiparallel zur zweiten Richtung ist. "Im Wesentlichen antiparallel" ist hierbei so zu verstehen, dass die zweite und dritte Richtung so zueinander stehen, dass sich die Anschlussoptionen über die zweiten und dritten Öffnungen im Rahmen der üblichen Toleranzen problemlos realisieren lassen. Die dritten Öffnungen erlauben damit eine zu den zweiten Öffnungen äquivalente Anschlussmöglichkeit der Kabel. Es ist eine sehr große Anzahl von Anschlussoptionen geschaffen. Gleichzeitig gestaltet sich für alle Optionen der Anschluss der Kabel äußerst unkompliziert und kundenfreundlich.

Vorzugsweise sind in der Gehäusewand zumindest zwei vierte Öffnungen zur Durchführung jeweils eines der Kabel so angeordnet, dass alle in einer vierten Richtung durch die vierten Öffnungen in das Gehäuse geführten und in der vierten Richtung innerhalb des Gehäuses weiterverlaufenden Kabel jeweils auf genau eines der Kontaktelemente treffen, wobei die vierte Richtung im Wesentlichen antiparallel zur ersten Richtung ist. "Im Wesentlichen antiparallel" ist hierbei so zu verstehen, dass die erste und vierte Richtung so zueinander stehen, dass sich die Anschlussoptionen über die ersten und vierten Öffnungen im Rahmen der üblichen Toleranzen problemlos realisieren lassen. Insbesondere können die Kabel direkt auf jeweils eines der Kontaktelemente treffen und mit diesem direkt elektrisch verbindbar sein. Damit ist eine vierte Anschlussoption und eine verbesserte Einsatzmöglichkeit der Anschlussvorrichtung geschaffen. Der Anschluss der Kabel kann von sehr vielen verschiedenen Richtungen erfolgen.

Ein erfindungsgemäßer Bausatz umfasst eine Anschlussvorrichtung mit einem Aufnahmeelement sowie zumindest eine Leiterschiene, welche mit einem der zumindest zwei Kontaktelemente einerseits und mit einem der Kabel andererseits elektrisch verbindbar ist. Schließlich umfasst der Bausatz auch zumindest ein Unterstützungselement, welches für eine Abstützung der zumindest einen Leiterschiene ausgebildet ist. Der Bausatz umfasst damit sehr wenige Elemente, mit denen dennoch ein sehr variabler Anschluss der Kabel ermöglicht wird. Will man von dem Anschluss der Kabel mit Führung in der ersten Richtung zu einem Anschluss der Kabel mit Führung in der zweiten Richtung übergehen, so sind lediglich einige Leiterschienen mit den Kontaktelementen elektrisch zu verbinden und hierbei von den Unterstützungselementen abzustützen. Für die Unterstützungselemente stehen bereits geeignete Aufnahmeelemente in der Anschlussvorrichtung zur Verfügung, welche deren räumliche Anordnung vorgeben. Wird von einer Anschlussoption zu einer anderen Anschlussoption übergegangen, sind lediglich die Leiterschienen und Unterstützungselemente räumlich neu anzuordnen, ohne dass es erheblicher baulicher Veränderungen der Anschlussvorrichtung bedürfte.

Vorzugsweise ist das zumindest eine Unterstützungselement aus einem elektrisch isolierenden Material ausgebildet. Dann ist ein unerwünschter elektrischer Kontakt zwischen einer Leiterschiene bzw. einem Kabel und einem Aufnahmeelement sicher vermieden.

Eine erfindungsgemäße elektrische Maschine umfasst eine erfindungsgemäße Anschlussvorrichtung. Bei der elektrischen Maschine kann es sich insbesondere um einen Elektromotor handeln, der zum Antrieb eines Fahrzeugs dient. Der Elektromotor ist dann insbesondere ein Traktionsmotor. Alternativ kann auch ein Generator als elektrische Maschine vorgesehen sein.

Ein erfindungsgemäßes Fahrzeug umfasste eine erfindungsgemäße elektrische Maschine. Die elektrische Maschine kann vorzugsweise als Elektromotor, und dann insbesondere als Radnabenmotor ausgebildet sein. Bei dem Fahrzeug kann es sich insbesondere um einen Nutzkraftwagen, vorzugsweise einen Muldenkipper oder einen Mining-Truck, handeln.

Ein erfindungsgemäßes Verfahren dient zum Anschließen zumindest zweier elektrischer Kabel an eine erfindungsgemäße Anschlussvorrichtung. Es umfasst die folgenden Schritte:
a) Auswählen einer der zumindest zwei zweiten Öffnungen, sodass ein in der zweiten Richtung durch die ausgewählte Öffnung in das Gehäuse geführtes und in der zweiten Richtung geradlinig innerhalb des Gehäuses weiter verlaufendes Kabel direkt auf genau eines der Kontaktelemente trifft;
b) Durchführen eines ersten der zumindest zwei Kabel in der zweiten Richtung durch die in Schritt a) ausgewählte Öffnung und geradliniges Weiterführen dieses Kabels in der zweiten Richtung innerhalb des Gehäuses, bis es auf eines der Kontaktelemente trifft;
c) Direktes elektrisches Verbinden des in Schritt b) geführten Kabels mit dem in Schritt b) getroffenen Kontaktelement;
d) Auswählen einer der zumindest zwei zweiten Öffnungen, welche nicht der in Schritt a) ausgewählten Öffnung entspricht;
e) Durchführen eines zweiten der zumindest zwei Kabel in der zweiten Richtung durch die in Schritt d) ausgewählte Öffnung und geradliniges Weiterführen dieses Kabels in der zweiten Richtung innerhalb des Gehäuses; und
f) Elektrisches Verbinden des in Schritt e) geführten Kabels mit einem der Kontaktelemente, welches nicht dem in Schritt b) getroffenen Kontaktelement entspricht, über eine Leiterschiene.

Die mit Bezug auf die erfindungsgemäße Anschlussvorrichtung dargestellten bevorzugten Ausführungsformen und deren Vorteile gelten entsprechend für den erfindungsgemäßen Bausatz, die erfindungsgemäße elektrische Maschine, das erfindungsgemäße Fahrzeug sowie das erfindungsgemäße Verfahren.

Weitere Merkmale der Erfindung ergeben sich aus den Ansprüchen, den Figuren und der Figurenbeschreibung. Die vorstehend in der Figurenbeschreibung genannten Merkmale und Merkmalskombinationen wie auch die in der Figurenbeschreibung genannten Merkmale und Merkmalskombinationen und/oder die in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen.

Anhand von Ausführungsbeispielen wird die Erfindung im Folgenden näher erläutert. Es zeigen:
- FIG 1: einen Klemmkasten, in den Kabel in einer ersten Richtung geführt sind; und
- FIG 2: einen Klemmkasten, in den Kabel in einer zweiten Richtung geführt sind.

In den Figuren sind gleiche oder funktionsgleiche Elemente mit den gleichen Bezugszeichen versehen.

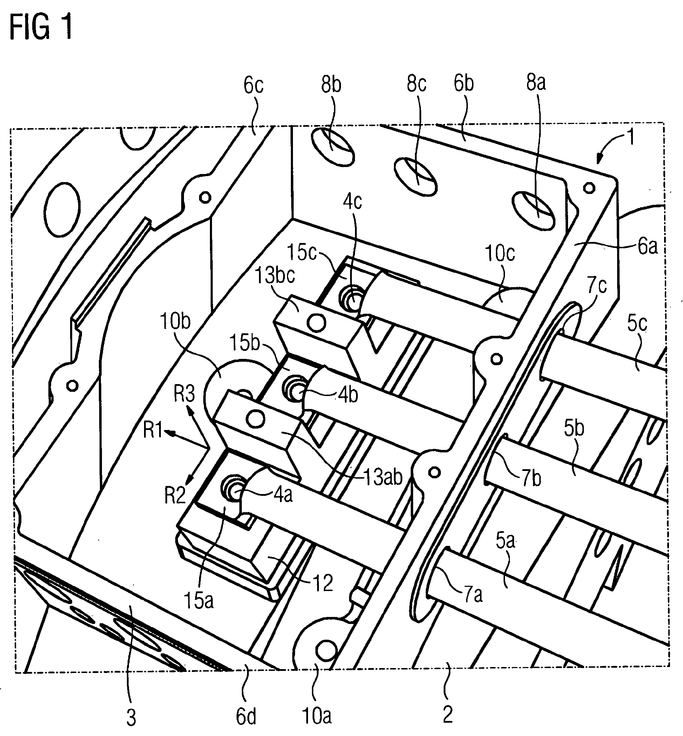

FIG 1 zeigt eine Anschlussvorrichtung, welche als Klemmkasten 1 ausgebildet ist. Der Klemmkasten 1 ist auf einem Elektromotor 2 angeordnet. Bei dem Elektromotor 2 handelt es sich um einen Fahrmotor für Mining-Trucks, der von einem Gussgehäuse umschlossen ist. Der Klemmkasten 1 ist als Teil dieses Gussgehäuses ausgebildet. Der Klemmkasten 1 umfasst ein Gehäuse 3 mit vier zueinander senkrechten Gehäusewandseiten 6a, 6b, 6c und 6d.

In der Gehäusewandseite 6a sind drei erste Öffnungen 7a, 7b und 7c ausgebildet, welche einen Zugang zum Innenraum des Klemmkastens 1 ermöglichen. Ein Kabel 5a ist senkrecht durch die erste Öffnung 7a durch die Gehäusewandseite 6a in den Innenraum des Gehäuses 3 geführt. Innerhalb des Gehäuses 3 verläuft das Kabel 5a in derselben Richtung weiter, in der es durch die erste Öffnung 7a geführt wurde; nämlich geradlinig in einer ersten Richtung R1. Im Hinblick auf die Motordrehachse des Elektromotors 2 kann die Richtung R1 auch als axiale Richtung bezeichnet werden. Völlig identisch sind die Kabel 5b und 5c durch die ersten Öffnungen 7b und 7c in den Klemmkasten 1 geführt. Die Kabel 5a, 5b und 5c verlaufen damit parallel zueinander. Sie sind alle in den ersten Öffnungen 7a, 7b und 7c durch nicht dargestellte Kabelverschraubungen fixiert. Die ersten Öffnungen 7a, 7b und 7c sind Bohrungen in der Gehäusewandseite 6a.

Die Kabel 5a, 5b und 5c besitzen an ihren Enden Kabelschuhe 15a, 15b und 15c, welche eine zentrale Bohrung aufweisen, mit der sich die Kabel 5a, 5b und 5c an zugehörigen Kontaktelementen 4a, 4b und 4c befestigen lassen. Die Kontaktelemente 4a, 4b und 4c sind in einem aus isolierendem Material ausgebildeten Sockelelement 12 eingebettet. Sie sind lediglich von einer Seite zugänglich, welche in der Ebene liegt, die durch die Richtung R1 und eine hierzu senkrechte Richtung R2 aufgespannt wird. Die Normale dieser Kontaktelementseiten wird durch die Richtung R3 gebildet. Die Richtungen R1, R2 und R3 stehen also alle senkrecht aufeinander. Die Kontaktelemente 4a, 4b und 4c weisen eine Bohrung auf, sodass gemeinsam mit den Bohrungen in den Kabelschuhen 15a, 15b und 15c die Kabel 5a, 5b und 5c mit nicht dargestellten Schrauben an den Kontaktelementen 4a, 4b und 4c befestigbar sind. Die Kabel 5a, 5b und 5c treffen die Kontaktelemente 4a, 4b und 4c direkt und sind mit diesen direkt elektrisch verbindbar.

Zwischen den jeweils benachbarten Kontaktelementen 4a und 4b bzw. 4b und 4c ist jeweils ein Isoliersteg 13ab bzw. 13bc ausgebildet. Dieser verhinderet unter anderem, dass ein in Ht Richtung -R3 auf das Sockelelement 12 aufgebrachtes Metallteil einen unerwünschten Kurzschluss zwischen den benachbarten Kontaktelementen 4a, 4b und 4c verursachen könnte. Zudem bilden sie eine Abstützung für einen in FIG 1 nicht gezeigten Deckel des Klemmkastens 1, welcher diesen von oben her abschließt und sich senkrecht zur Richtung R3 erstreckt.

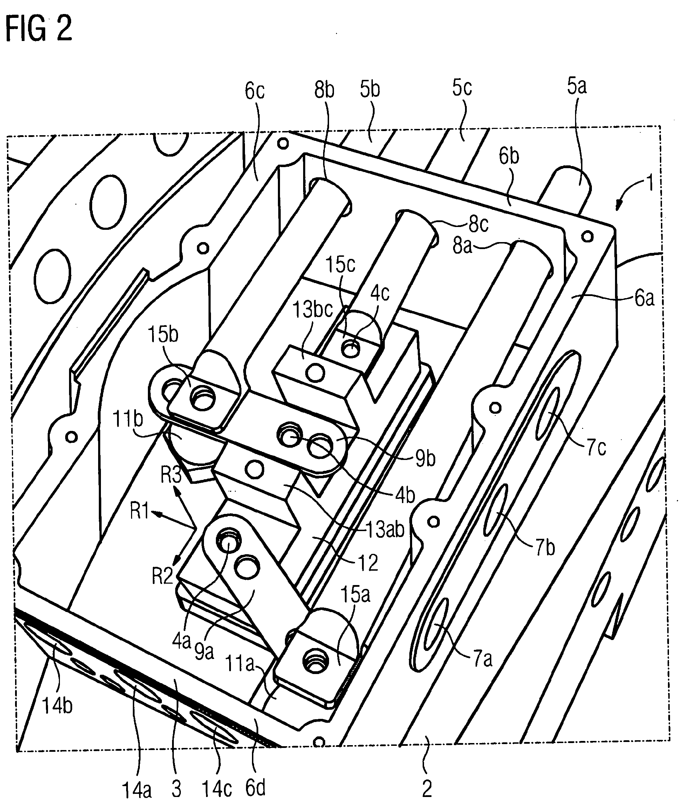

Im Klemmkasten 1 sind an einer zweiten Gehäusewandseite 6b drei weitere zweite Öffnungen 8a, 8b und 8c ausgebildet. Diese ermöglichen einen weiteren Zugang in den Innenraum des Gehäuses 3. Dies erlaubt eine zweite Anschlussoption für die Kabel 5a, 5b und 5c, wie sie in FIG 2 dargestellt ist. Das Kabel 5c wird hierbei durch die zweite Öffnung 8c in Richtung R2 in den Klemmkasten 1 geführt und verläuft innerhalb des Klemmkastens 1 weiterhin geradlinig in Richtung R2. Der Kabelschuh 15c des Kabels 5c trifft direkt auf das Kontaktelement 4c und ist mit diesem direkt elektrisch verbindbar. Dies gilt jedoch nicht für die Kabel 5a und 5b, welche parallel zum Kabel 5c durch die zweiten Öffnungen 8a und 8b in das Gehäuse 3 geführt sind. Auch sie verlaufen innerhalb des Gehäuses 3 geradlinig in Richtung R2 und können deshalb die Kontaktelemente 4a und 4b nicht mehr direkt treffen. Deshalb wird eine elektrische Brückenlösung bereitgestellt.

Wie man der FIG 1 entnimmt, ist der Klemmkasten 1 geeignet ausgebildet, um die zweite, in FIG 2 dargestellte Anschlussoption einfach und unkompliziert zu ermöglichen. Es sind nämlich Isolierstützer-Aufnahmegewinde 10a und 10b vorgesehen, welche geeignete Soll-Positionen für Isolierstützer 11a und 11b vorgeben. Das Kabel 5a kann deshalb mit dem Kontaktelement 4a elektrisch wie folgt verbunden werden: Auf das Isolierstützer-Aufnahmegewinde 10a wird der Isolierstützer 11a aufgesetzt und mithilfe einer Schraube fixiert. Sodann wird eine Leiterschiene 9a, welche innere und äußere Bohrlöcher für Schrauben aufweist, so auf den Isolierstützer 11a und das Kontaktelement 4a gesetzt, dass jeweils das äußere Schraubenloch oberhalb der im Kontaktelement 4a und im Isolierstützer 11a vorgesehenen Schraubenlöcher zu liegen kommt. Sodann wird die Leiterschiene 9a über diese Schraublöcher mit dem Kontaktelement 4a einerseits und gegebenenfalls mit dem Isolierstützer 11a andererseits verbunden. Das durch die zweite Öffnung 8a in den Innenraum des Klemmkastens 1 geführte Kabel 5a kann über den Kabelschuh 15a an der Leiterschiene 9a befestigt werden. Es ist ein elektrischer Kontakt zwischen dem Kontaktelement 4a und dem Kabel 5a über die Leiterschiene 9a hergestellt.

Ebenso wie das Isolierstützer-Aufnahmegewinde 10a dem Kontaktelement 4a zugeordnet ist, ist das Isolierstützer-Aufnahmegewinde 10b dem Kontaktelement 4b zugeordnet. Eine elektrische Verbindung zwischen dem Kabel 5b und dem Kontaktelement 4b erfolgt nun auf ganz analoge Weise wie zwischen dem Kabel 5a und dem Kontaktelement 4a. Im Ausführungsbeispiel werden jedoch die jeweils inneren Schraublöcher der Leiterschiene 9b verwendet.

Auch die Kabel 5a, 5b und 5c sind wiederum über nicht dargestellte Kabelverschraubungen in den Bohrungen 8a, 8b und 8c fixiert. Hinsichtlich der Rotationsachse des Elektromotors 2 kann die Richtung R2 auch als Tangentialrichtung bezeichnet werden.

Im Ausführungsbeispiel sind auch dritte Öffnungen 14a, 14b und 14c in der Gehäusewandseite 6d ausgebildet, die für die Kabel 5a, 5b und 5c einen Zugang in den Klemmkasten 1 in Richtung -R2 ermöglichen. Wählt man diese Anschlussoption und nimmt als Ausgangspunkt die in Fig. 2 realisierte Anschlussoption, so muss lediglich der Isolierstützer 11a in das Isolierstützer-Aufnahmegewinde 10c umgesetzt werden und die Leiterschiene 9a nunmehr mit dem Kontaktelement 4c verbunden werden. Um eine gleichartige elektrische Kontaktierung zu erreichen, wird das Kabel 5c in Richtung -R2 durch die dritte Öffnung 14c in den Klemmkasten 1 geführt und über die versetzte Leiterschiene 9a mit dem Kontaktelement 4c elektrisch verbunden. Die elektrische Kontaktierung des Kabels 5b mit dem Kontaktelement 4b bleibt bestehen, nun jedoch mit einem durch die dritte Öffnung 14b geführten Kabel 5b. Bei der dritten Anschlussoption wird das Kabel 5a durch die dritte Öffnung 14a geführt und trifft direkt auf das Kontaktelement 4a, ohne dass es einer Leiterschiene bedarf.

Im Ausführungsbeispiel befindet sich ein Montageflansch auf der Gehäusewandseite 6c des Klemmkastens 1. Deshalb sind hier keine Öffnungen in der Gehäusewandseite 6c vorgesehen. Bei einer alternativen Ausführung ohne Montageflansch, könnten die Kabel 5a, 5b und 5c jedoch auch durch vierte Öffnungen geführt sein, die in der Gehäusewandseite 6c ausgebildet sind. Dann ergäbe sich eine zu FIG 1 äquivalente Anschlussoption.

Die jeweils nicht genutzten Kabelaustrittsöffnungen können mit Blindstopfen und der gesamte Klemmkasten 1 mit einem nicht dargestellten Deckel verschlossen werden. Beispielsweise können bei der in FIG 1 dargestellten Anschlussoption die zweiten Öffnungen 8a, 8b und 8c sowie die dritten Öffnungen 14a, 14b und 14c durch Blindstopfen verschlossen sein.

Die Erfindung erlaubt den Leistungsanschluss von Starkstromgeräten auch bei beengten Platzverhältnissen. Es ist ein standardisierter Klemmkasten 1 mit vielen verschiedenen Anschlussoptionen geschaffen. Statt individueller Kundenlösungen können alle zwei, drei bzw. vier Anschlussarten mit einem Gussteil, einer Bearbeitung und einer Bestellnummer realisiert werden. Der Kunde kann selbst entscheiden, welche Anschlussoption für ihn am besten geeignet ist und sich gegebenenfalls erst nach Lieferung des Elektromotors 2 mit Klemmkasten 1 für eine Anschlussoption entscheiden. Er kann gegebenenfalls auch mehrere Varianten ausprobieren. Hierbei müssen jeweils immer nur maximal zwei Bauteile (Leiterschiene 9a, 9b und Isolierstützer 11a, 11b) versetzt werden. Für unterschiedliche Anwendungen bzw. Kunden können identische Produkte angeboten und verkauft werden. Durch Stückzahldegression und verringerten Energieaufwand ergeben sich Kosteneinsparungen und bessere Marktchancen.

Im Ausführungsbeispiel stehen die Gehäusewandseiten 6a, 6b, 6c und 6d senkrecht aufeinander und sind als Gussteil einstückig ausgebildet. Es sind hier viele verschiedene alternative Ausführungsformen denkbar. Beispielsweise können die Gehäusewandseiten 6a, 6b, 6c und 6d in Aufsicht aus Richtung -R3 auch trapezförmig zueinander angeordnet sein. Auch eine abgerundete, im Wesentlichen ovale Ausführungsform ist denkbar. Insbesondere muss das Gehäuse 3 nicht einstückig ausgebildet sein. Beispielsweise können die ersten Öffnungen 7a, 7b und 7c in einer Adapterplatte ausgebildet sein, welche auf eine in Richtung R2 langgezogene Öffnung in der Gehäusewandseite 6a aufgesetzt und fixiert ist. Die Adapterplatte ist dann als Bestandteil des Gehäuses 3 anzusehen, welches dann mehrstückig ausgebildet ist. Die Adapterplatte ist dann Teil einer Gehäusewand.

## Patentansprüche

1. Anschlussvorrichtung (1) zum Anschluss zumindest zweier elektrischer Kabel (5a,5b,5c) an eine elektrische Maschine (2) eines Fahrzeugs, mit einem Gehäuse (3) und zumindest zwei Kontaktelementen (4a,4b,4c), wobei in einer Gehäusewand (6a) zumindest zwei erste Öffnungen (7a,7b,7c) zur Durchführung jeweils eines der Kabel (5a,5b,5c) so angeordnet sind, dass alle in einer ersten Richtung (R1) durch die ersten Öffnungen (7a,7b,7c) in das Gehäuse (3) geführten und in der ersten Richtung (R1) geradlinig innerhalb des Gehäuses (3) weiterverlaufenden Kabel (5a,5b,5c) jeweils auf genau eines der Kontaktelemente (4a,4b,4c) treffen, **dadurch gekennzeichnet, dass** in der Gehäusewand (6b) zumindest zwei zweite Öffnungen (8a,8b,8c) zur Durchführung jeweils eines der Kabel (5a,5b,5c) so angeordnet sind, dass unter den in einer zweiten Richtung (R2) durch die zweiten Öffnungen (8a,8b,8c) in das Gehäuse (3) geführten und in der zweiten Richtung (R2) geradlinig innerhalb des Gehäuses (3) weiterverlaufenden Kabel (5a,5b,5c) ausschließlich eines (5c) direkt auf genau eines der Kontaktelemente (4c) trifft und mit diesem elektrisch verbindbar ist und alle übrigen (5a, 5b) mit jeweils einem der übrigen Kontaktelemente (4a,4b) mittels jeweils einer Leiterschiene (9a, 9b) elektrisch verbindbar sind, wobei die zweite Richtung (R2) im Wesentlichen senkrecht zur ersten Richtung (R1) ist.

2. Anschlussvorrichtung (1) nach Anspruch 1, **gekennzeichnet durch** ein Aufnahmeelement (10a,10b,10c), welches einem der Kontaktelemente (4a,4b,4c) zugeordnet ist, wobei eine räumliche Anordnung eines Unterstützungselements (11a,11b) für die Abstützung einer der Leiterschienen (9a, 9b) **durch** das Aufnahmeelement (10a,10b) vorgegeben ist, und wobei das Unterstützungselement (11a,11b) an dem Aufnahmeelement (10a,10b) befestigbar ist.

3. Anschlussvorrichtung (1) nach Anspruch 1 oder 2, **da - durch gekennzeichnet,** dass die zumindest zwei Kontaktelemente (4a,4b,4c) entlang einer Geraden angeordnet sind, welche in der zweiten Richtung (R2) verläuft.

4. Anschlussvorrichtung (1) nach einem der vorhergehenden Ansprüche, **dadurch gekennzeichnet,**
**dass** die zumindest zwei Kontaktelemente (4a,4b,4c) in einem Sockelelement (12) eingebettet sind und ausschließlich von einer Seite des Kontaktelements (4a,4b,4c) elektrisch kontaktierbar sind, welche in der von der ersten (R1) und zweiten Richtung (R2) aufgespannten Ebene liegt.

5. Anschlussvorrichtung (1) nach Anspruch 4, **dadurch gekennzeichnet, dass** an dem Sockelelement (12) zumindest ein Isoliersteg (13ab,13bc) ausgebildet ist, welcher zwischen zwei benachbarten (4a,4b;4b,4c) unter den zumindest zwei Kontaktelementen (4a,4b,4c) so verläuft, dass eine gleichzeitige elektrische Kontaktierung der zwei benachbarten Kontaktelemente (4a,4b;4b,4c) durch ein geradlinig entlang der zweiten Richtung (R2) verlaufendes Kabel (5c) verhindert ist.

6. Anschlussvorrichtung (1) nach einem der vorhergehenden Ansprüche, **dadurch gekennzeichnet,**
**dass** in der Gehäusewand (6d) zumindest zwei dritte Öffnungen (14a,14b,14c) zur Durchführung jeweils eines der Kabel (5a, 5b,5c) so angeordnet sind, dass unter den in einer dritten Richtung (-R2) durch die dritten Öffnungen (14a,14b,14c) in das Gehäuse (3) geführten und in der dritten Richtung (-R2) geradlinig innerhalb des Gehäuses (3) weiterverlaufenden Kabel (5a,5b,5c) ausschließlich eines (5a) direkt auf genau eines der Kontaktelemente (4a) trifft und mit diesem elektrisch verbindbar ist und alle übrigen (5b,5c) mit jeweils einem der übrigen Kontaktelemente (4b,4c) mittels jeweils einer Leiterschiene (9b, 9a) elektrisch verbindbar sind, wobei die dritte Richtung (-R2) im Wesentlichen antiparallel zur zweiten Richtung (R2) ist.

7. Anschlussvorrichtung (1) nach einem der vorhergehenden Ansprüche, **dadurch gekennzeichnet,**
**dass** in der Gehäusewand (6c) zumindest zwei vierte Öffnungen zur Durchführung jeweils eines der Kabel (5a,5b,5c) so angeordnet sind, dass alle in einer vierten Richtung (-R1) durch die vierten Öffnungen in das Gehäuse (3) geführten und in der vierten Richtung (-R1) geradlinig innerhalb des Gehäuses (3) weiterverlaufenden Kabel (5a,5b,5c) jeweils auf genau eines der Kontaktelemente (4a,4b,4c) treffen, wobei die vierte Richtung (-R1) im Wesentlichen antiparallel zur ersten Richtung (R1) ist.

8. Bausatz mit einer Anschlussvorrichtung (1) nach Anspruch 2 oder nach einem der Ansprüche 3 bis 7 im Rückbezug auf Anspruch 2, mit zumindest einer Leiterschiene (9a,9b), welche mit einem der zumindest zwei Kontaktelemente (4a,4b,4c) einerseits und mit einem der Kabel (5a,5b,5c) andererseits elektrisch verbindbar ist, und mit zumindest einem Unterstützungselement (11a, 11b), welches für eine Abstützung der zumindest einen Leiterschiene (9a,9b) ausgebildet ist.

9. Bausatz nach Anspruch 8, **dadurch gekennzeichnet, dass** das zumindest eine Unterstützungselement (11a,11b) aus einem elektrisch isolierenden Material ausgebildet ist.

10. Elektrische Maschine, insbesondere Elektromotor zum Antrieb eines Fahrzeugs, mit einer Anschlussvorrichtung (1) nach einem der Ansprüche 1 bis 7.

11. Fahrzeug, insbesondere Nutzkraftwagen, mit einer elektrischen Maschine nach Anspruch 10, welche insbesondere als Radnabenmotor ausgebildet ist.

12. Verfahren zum Anschließen zumindest zweier elektrischer Kabel (5a,5b,5c) an eine Anschlussvorrichtung (1) nach einem der Ansprüche 1 bis 7, mit den Schritten:
a) Auswählen einer der zumindest zwei zweiten Öffnungen (8a, 8b,8c), so dass ein in der zweiten Richtung (R2) durch die ausgewählte Öffnung (8c) in das Gehäuse (3) geführtes und in der zweiten Richtung (R2) geradlinig innerhalb des Gehäuses (3) weiterverlaufendes Kabel (5c) direkt auf genau eines der Kontaktelemente (4c) trifft;
b) Durchführen eines ersten (5c) der zumindest zwei Kabel (5a,5b,5c) in der zweiten Richtung (R2) durch die in Schritt a) ausgewählte Öffnung (8c) und geradliniges Weiterführen dieses Kabels (5c) in der zweiten Richtung (R2) innerhalb des Gehäuses (3) bis es auf eines der Kontaktelemente (4c) trifft;
c) Direktes elektrisches Verbinden des in Schritt b) geführten Kabels (5c) mit dem in Schritt b) getroffenen Kontaktelement (4c);
d) Auswählen einer (8a;8b) der zumindest zwei zweiten Öffnungen (8a,8b), welche nicht der in Schritt a) ausgewählten Öffnung (8c) entspricht;
e) Durchführen eines zweiten (5a;5b) der zumindest zwei Kabel (5a, 5b) in der zweiten Richtung (R2) durch die in Schritt d) ausgewählte Öffnung (8a;8b) und geradliniges Weiterführen dieses Kabels (5a;5b) in der zweiten Richtung (R2) innerhalb des Gehäuses (3); und
f) Elektrisches Verbinden des in Schritt e) geführten Kabels (5a;5b) mit einem der Kontaktelemente (4a;4b), welches nicht dem in Schritt b) getroffenen Kontaktelement (4c) entspricht, über eine Leiterschiene (9a;9b).

## Claims

1. Connecting device (1) for connecting at least two electric cables (5a, 5b, 5c) to an electric machine (2) of a vehicle, with a housing (3) and at least two contact elements (4a, 4b, 4c), wherein at least two first openings (7a, 7b, 7c) for the passage of one of the cables (5a, 5b, 5c) in each case are arranged in a housing wall (6a) so that all cables (5a, 5b, 5c) routed in a first direction (R1) through the first openings (7a, 7b, 7c) into the housing and (3) and running onwards in the first direction (R1) in a straight line within the housing (3) each meet precisely one contact element (4a, 4b, 4c), **characterised in that** at least two second openings (8a, 8b, 8c) for the passage of one of the cables (5a, 5b, 5c) in each case are arranged in the housing wall (6b) so that, of the cables routed in a second direction (R2) through the second openings (8a, 8b, 8c) into the housing (3) and running onwards in the second direction (R2) in a straight line within the housing (3), exclusively one (5c) directly meets precisely one of the contact elements (4c) and is able to be connected electrically to said element and all remaining cables (5a, 5b) are able to be electrically connected to one of the remaining contact elements (4a, 4b) by means of a conductor bar (9a, 9b) in each case, wherein the second direction (R2) is essentially at right angles to the first direction (R1).

2. Connecting device (1) according to claim 1, **characterised by** a receiving element (10a, 10b, 10c), which is assigned to one of the contact elements (4a, 4b, 4c), wherein a spatial arrangement of a support element (11a, 11b) for the support of one of the conductor bars (9a, 9b) is predetermined by the receiving element (10a, 10b), and wherein the support element (11a, 11b) is able to be fastened to the receiving element (10a, 10b).

3. Connecting device (1) according to claim 1 or 2, **characterised in that** the at least two contact elements (4a, 4b, 4c) are arranged along a straight line which runs in the second direction (R2).

4. Connecting device (1) according to one of the preceding claims, **characterised in that** the at least two contact elements (4a, 4b, 4c) are embedded in the base element (12) and are able to be electrically contacted exclusively from one side of the contact element (4a, 4b, 4c), which lies in the plane spanned by the first (R1) and second direction (R2).

5. Connecting device (1) according to 4, **characterised in that** at least one isolating bar (13ab, 13bc) is embodied on the base element, which runs between two adjacent elements (4a, 4b ;4b, 4c) of the at least two contact elements (4a, 4b, 4c) so that a simultaneous electrical contacting of the two adjacent contact elements (4a, 4b; 4b, 4c) by a cable (5c) running in a straight line in the second direction (R2) is prevented.

6. Connecting device (1) according to one of preceding claims, **characterised in that** at least two third openings (14a, 14b, 14c) for the passage of one of the cables (5a, 5b, 5c) in each case are arranged in the housing wall (6d) so that, of the cables (5a, 5b, 5c) routed in a third direction (-R2) through the third openings (14a, 14b, 14c) into the housing (3) and running onwards in the third direction (-R2) in a straight line within the housing (3), exclusively one (5a) directly meets precisely one of the contact elements (4a) and is able to be connected electrically to said element and all remaining cables (5b, 5c) are able to be connected electrically to one of the remaining contact elements (4b, 4c) by means of one conductor bar (9b, 9a) in each case, wherein the third direction (-R2) is essentially antiparallel to the second direction (R2).

7. Connecting device (1) according to one of the preceding claims, **characterised in that** at least two fourth openings for the passage of one of the cables (5a, 5b, 5c) in each case are arranged in the housing wall (6c) so that all cables (5a, 5b, 5c) routed into the housing (3) through the fourth openings in a fourth direction (-R1) and running in a straight line in the fourth direction (-R1) within the housing (3) meet precisely one of the contact elements (4a, 4b, 4c) in each case, wherein the fourth direction (-R1) is essentially antiparallel to the first direction (R1).

8. Kit with a connecting device (1) according to claim 2 or according to one of claims 3 to 7 referring back to claim 2, with a least one conductor bar (9a, 9b), which is able to be connected electrically on one side to one of the at least two contact elements (4a, 4b, 4c) and on the other side to one of the cables (5a, 5b, 5c), and with at least one support element (11a, 11b), which is embodied for support of the at least one conductor bar (9a, 9b).

9. Kit according to claim 8, **characterised in that** the at least one support element (11a, 11b) is embodied from an electrically isolating material.

10. Electric machine, an especially an electric motor for driving a vehicle, with a connecting device (1) according to one of claims 1 to 7.

11. Vehicle, especially a commercial vehicle, with an electrical machine according to claim 10, which is especially embodied as a wheel hub motor.

12. Method for connecting a least two electric cables (5a, 5b, 5c) to a connecting device (1) according to one of claims 1 to 7, with the following steps:
a) Selection of one of the at least two second openings (8a, 8b, 8c) so that a cable (5c) routed through the selected opening (8c) in the second direction (R2) into the housing (3) and continuing onwards in a straight line in the second direction (R2) within the housing (3) directly meets precisely one of the contact elements (4c);
b) Passing a first (5c) of the at least two cables (5a, 5b, 5c) in the second direction (R2) through the opening (8c) selected in step a) and onwards routing in a straight line of this cable (5c) in the second direction (R2) within the housing (3) until it meets one of the contact elements (4c);
c) Direct electrical connection of the cable (5c) routed in step a) with the contact element (4c) met in step b);
d) Selection of one (8a; 8b) of the at least two second openings (8a, 8b) which does not correspond to the opening (8c) selected in step a);
e) Passing a second (5a; 5b) of the at least two cables (5a, 5b) in the second direction (R2) through the opening (8a; 8b) selected in step d) and onwards routing of this cable (5a; 5b) in a straight line in the second direction (R2) within the housing (3); and
f) Electrical connection of the cable (5a; 5b) routed in step e) with one of the contact elements (4a; 4b), which does not correspond to the contact element (4c) met in step b), via a conductor bar (9a; 9b).

## Revendications

1. Dispositif (1) de raccordement pour raccorder au moins deux câbles (5a, 5b, 5c) électriques à un moteur (2) électrique d'un véhicule, comprenant un boîtier (3) et au moins deux éléments (4a, 4b, 4c) de contact, au moins deux premières ouvertures (7a, 7b, 7c) pour le passage respectivement de l'un des câbles (5a, 5b, 5c) étant ménagées dans une paroi (6a) du boîtier de manière à ce que tous les câbles (5a, 5b, 5c), guidés dans une première direction (R1) par les premières ouvertures (7a, 7b, 7c) dans le boîtier (3) et continuant en ligne droite dans la première direction (R1) à l'intérieur du boîtier (3), arrivent respectivement exactement sur l'un des éléments (4a, 4b, 4c) de contact, **caractérisé en ce qu'**il est ménagé dans la paroi (6b) du boîtier au moins deux deuxièmes ouvertures (8a, 8b, 8c) de passage de respectivement l'un des câbles (5a, 5b, 5c) de manière à ce que, parmi les câbles (5a, 5b, 5c) guidés dans une deuxième direction (R2) par les deuxièmes ouvertures (8a, 8b, 8c) du boîtier (3) et continuant en ligne droite dans la deuxième direction (R2) à l'intérieur du boîtier (3), exclusivement l'un (5c) arrive directement sur exactement l'un des éléments (4c) de contact et peut être relié électriquement à celui-ci et tous les autres (5a, 5b) peuvent être reliés électriquement à respectivement l'un des autres éléments (4a, 4b) de contact au moyen respectivement d'une barre (9a, 9b) conductrice, la deuxième direction (R2) étant sensiblement perpendiculaire à la première direction (R1).

2. Dispositif (1) de raccordement suivant la revendication 1, **caractérisé par** un élément (10a, 10b, 10c) de réception, qui est associé à l'un des éléments (4a, 4b, 4c) de contact, un agencement dans l'espace d'un élément (11a, 11b) d'appui pour l'appui de l'une des barres (9a, 9b) conductrices par l'élément (10a, 10b) de réception étant prévu et l'élément (11a, 11b) d'appui peut être fixé à l'élément (10a, 10b) de réception.

3. Dispositif (1) de raccordement suivant la revendication 1 ou 2, **caractérisé en ce que** les au moins deux éléments (4a, 4b, 4c) de contact sont disposés suivant une droite qui s'étend dans la deuxième direction (R2).

4. Dispositif (1) de raccordement suivant l'une des revendications précédentes, **caractérisé en ce que** les au moins deux éléments (4a, 4b, 4c) de contact sont incorporés dans un élément (12) de socle et peuvent être mis en contact électriquement exclusivement par un côté de l'élément (4a, 4b, 4c) de contact, qui se trouve dans le plan passant par la première (R1) et la deuxième directions (R2).

5. Dispositif (1) de raccordement suivant la revendication 4, **caractérisé en ce qu'**il est formé sur l'élément (12) de socle au moins une réglette (13ab, 13bac) isolante, qui s'étend parmi les au moins deux éléments (4a, 4b, 4c) de contact entre deux éléments (4a, 4b; 4b, 4c) de contact voisins, de manière à empêcher une mise en contact électrique simultanée des deux éléments (4a, 4b; 4b, 4c) de contact voisins par un câble (5c) s'étendant en ligne droite dans la deuxième direction (R2).

6. Dispositif (1) de raccordement suivant l'une des revendications précédentes, **caractérisé en ce qu'**il est ménagé dans la paroi (6d) du boîtier au moins deux troisièmes ouvertures (14a, 14b, 14c) de passage respectivement de l'un des câbles (5a, 5b, 5c) de manière à ce que parmi les câbles (5a, 5b, 5c), guidés dans une troisième direction (R2) par les troisièmes ouvertures (14a, 14b, 14c) du boîtier (3) et continuant en ligne droite dans la troisième direction (R2) à l'intérieur du boîtier (3), exclusivement l'un (5a) arrive directement sur exactement l'un des éléments (4a) de contact et peut être relié électriquement à celui-ci et tous les autres (5b, 5c) peuvent être reliés électriquement à respectivement l'un des autres éléments (4b, 4c) de contact au moyen respectivement d'une barre (9b, 9a) conductrice, la troisième direction (-R2) étant sensiblement antiparallèle à la deuxième direction (R2).

7. Dispositif (1) de raccordement suivant l'une des revendications précédentes, **caractérisé en ce qu'**il est ménagé dans la paroi (6c) du boîtier au moins deux quatrièmes ouvertures de passage respectivement de l'un des câbles (5a, 5b, 5c) de manière à ce que tous les câbles (5a, 5b, 5c), guidés dans une quatrième direction (-R1) par les quatrièmes ouvertures du boîtier (3) et continuant en ligne droite dans la quatrième direction (-R1) à l'intérieur du boîtier (3), arrivent respectivement exactement sur l'un des éléments (4a, 4b, 4c) de contact, la quatrième direction (-R1) étant sensiblement antiparallèle à la première direction (R1).

8. Ensemble prêt à monter ayant un dispositif (1) de raccordement suivant la revendication 2 ou suivant l'une des revendications 3 à 7 se rapportant à la revendication 2, comprenant au moins une barre (9a, 9b) conductrice qui peut être reliée électriquement, d'une part, avec l'un des au moins deux éléments (4a, 4b, 4c) de contact et, d'autre part, avec l'un des câbles (5a, 5b, 5c) et comprenant au moins un élément (11a, 11b) d'appui constitué pour un appui de la au moins une barre (9a, 9b) conductrice.

9. Ensemble prêt à monter suivant la revendication 8, **caractérisé en ce que** le au moins un élément (11a, 11b) d'appui est en un matériau isolant électriquement.

10. Machine électrique, notamment moteur électrique de propulsion d'un véhicule, comprenant un dispositif (1) de raccordement suivant l'une des revendications 1 à 7.

11. Véhicule, notamment camion utilitaire, comprenant une machine électrique suivant la revendication 10, qui est constituée notamment sous la forme d'un moteur au moyeu de roue.

12. Procédé de raccordement d'au moins deux câbles (5a, 5b, 5c) électriques à un dispositif (1) de raccordement suivant l'une des revendications 1 à 7, comprenant les stades:
a) sélection de l'une des au moins deux deuxièmes ouvertures (8a, 8b, 8c) de manière à ce qu'un câble (5c), guidé dans la deuxième direction (R2) par l'ouverture (8c) sélectionnée du boîtier (3) et continuant en ligne droite dans la deuxième direction (R2) à l'intérieur du boîtier (3), arrive directement sur exactement l'un des éléments (4c) de contact ;
b) passage d'un premier (5c) des au moins deux câbles (5a, 5b, 5c) dans la deuxième direction (R2) dans l'ouverture (8c) sélectionnée au stade a) et continuation en ligne droite de ce câble (5c) dans la deuxième direction (R2) à l'intérieur du boîtier (3) jusqu'à ce qu'il arrive sur l'un des éléments (4c) de contact ;
c) liaison électrique directe du câble (5c) guidé au stade b) à l'élément (4c) de contact, sur lequel il est arrivé au stade b);
d) sélection de l'une (8a, 8b) des au moins deux deuxièmes ouvertures (8a, 8b), qui ne correspond pas à l'ouverture (8c) sélectionnée au stade a);
e) passage d'un deuxième (5a, 5b) des au moins deux câbles (5a, 5b) dans la deuxième direction (R2) dans l'ouverture (8a, 8b) sélectionnée au stade d) et continuation en ligne droite de ce câble (5a, 5b) dans la deuxième direction (R2) à l'intérieur du boîtier (3); et
f) liaison électrique du câble (5a, 5b) guidé au stade e) à l'un des éléments (4a, 4b) de contact, qui ne correspond pas à l'élément (4c) de contact sur lequel on est arrivé au stade b), par l'intermédiaire d'une barre (9a, 9b) conductrice.
